# EUROPÄISCHE PATENTSCHRIFT

(11) **EP 2 460 195 B1**
(45) Veröffentlichungstag und Bekanntmachung des Hinweises auf die Patenterteilung: **30.03.2016**
(21) Anmeldenummer: 10742784.1
(22) Anmeldetag: 23.07.2010
(51) Int. Cl.: H01L 35/16, H01L 35/34

(54) **VERFAHREN ZUR HERSTELLUNG THERMOELEKTRISCHER HALBLEITERMATERIALIEN UND SCHENKEL**
METHOD FOR PRODUCING THERMOELECTRIC SEMICONDUCTOR MATERIALS AND BRANCHES
PROCÉDÉ DE FABRICATION DE BRANCHES ET DE MATÉRIAUX SEMI-CONDUCTEURS THERMOÉLECTRIQUES

(30) Priorität: 27.07.2009 EP 09166438
(43) Veröffentlichungstag der Anmeldung: 06.06.2012
(73) Patentinhaber: BASF SE, 67056 Ludwigshafen (DE)
(72) Erfinder: STEFAN, Madalina, Andreea, 67063 Ludwigshafen (DE); DITSCHER, Michael, 67098 Bad Dürkheim (DE)
(86) Internationale Anmeldenummer: PCT/EP2010/060709
(87) Internationale Veröffentlichungsnummer: WO 2011/012547

(56) Entgegenhaltungen:
- EP-A1- 1 083 610
- DE-A1-102007 014 499
- US-A- 3 527 622
- US-A- 3 867 496
- US-A1- 2007 175 506
- Alexander Borshchevsky: "Preparation of thermoelectric materials from melts" In: D.M. Rowe (Editor): "CRC Handbook of" 31. Juli 1995 (1995-07-31), CRC Press , XP002613662 ISBN: 0849301467 das ganze Dokument

## Beschreibung

Die Erfindung betrifft ein Verfahren zur Herstellung thermoelektrischer Halbleitermaterialien und Schenkel sowie die Verwendung von Induktionsöfen zu ihrer Herstellung.

Thermoelektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis, wobei an einem Verbraucher im Stromkreis elektrische Arbeit verrichtet werden kann. Der dabei erzielte Wirkungsgrad der Konversion von Wärme in elektrische Energie wird thermodynamisch durch den Carnot-Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Bis heute werden jedoch nur Wirkungsgrade bis 6 % erzielt.

Legt man andererseits einen Gleichstrom an eine derartige Anordnung an, so wird Wärme von einer Seite zur anderen Seite transportiert. Eine derartige Peltier-Anordnung arbeitet als Wärmepumpe und eignet sich deshalb zur Kühlung von Apparateteilen, Fahrzeugen oder Gebäuden. Auch die Heizung über das Peltier-Prinzip ist günstiger als eine herkömmliche Heizung, weil immer mehr Wärme transportiert wird als dem zugeführten Energieäquivalent entspricht.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Der Vorteil der thermoelektrischen Generatoren liegt in ihrer äußersten Zuverlässigkeit. So arbeiten sie unabhängig von atmosphärischen Bedingungen wie Luftfeuchte; es erfolgt kein störungsanfälliger Stofftransport, sondern nur ein Ladungstransport; der Betriebsstoff wird kontinuierlich - auch katalytisch ohne freie Flamme - verbrannt, wodurch nur geringe Mengen an CO, NOₓ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit passt sich die thermoelektrische Energiewandlung äußerst flexibel in künftige Bedürfnisse wie Wasserstoffwirtschaft oder Energieerzeugung aus regenerativen Energien ein.

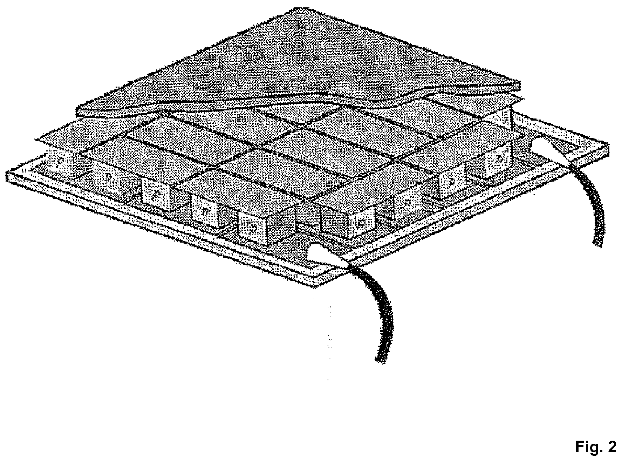

Ein thermoelektrisches Modul besteht aus p- und n-Schenkeln, die elektrisch in Reihe und thermisch parallel geschaltet sind. Figur 2 zeigt ein solches Modul.

Der klassische Aufbau besteht aus zwei Keramikplatten, zwischen denen die einzelnen Schenkel alternierend aufgebracht sind. Jeweils zwei Schenkel sind dabei elektrisch leitend über die Stirnflächen kontaktiert.

Neben der elektrisch leitfähigen Kontaktierung sind auf dem eigentlichen Material normalerweise noch verschiedene weitere Schichten aufgebracht, die als Schutzschichten oder als Lotschichten dienen. Letztlich wird der elektrische Kontakt zwischen zwei Schenkeln jedoch über eine Metallbrücke hergestellt.

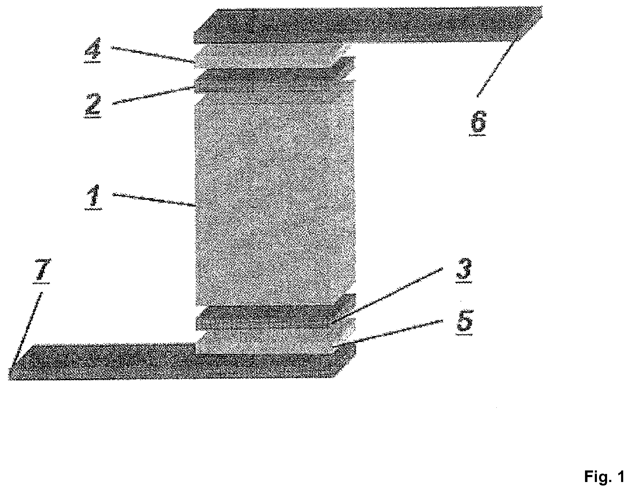

Ein wesentliches Element thermoelektrischer Bauteile ist die Kontaktierung. Die Kontaktierung stellt die physikalische Verbindung zwischen dem Material im "Herzen" des Bauteils (das für den gewünschten thermoelektrischen Effekt des Bauteils verantwortlich ist) und der "Außenwelt" her. Der Aufbau eines solchen Kontaktes ist in Fig. 1 schematisch dargestellt.

Das thermoelektrische Material **1** innerhalb des Bauteils sorgt für den eigentlichen Effekt des Bauteils. Dies ist ein thermoelektrischer Schenkel. Das Material **1** ist von einem elektrischen Strom und einem Wärmestrom durchflossen, um seinen Zweck in dem Gesamtaufbau zu erfüllen.

Das Material **1** ist an zumindest zwei Seiten über die Kontakte **4** und **5** mit den Zuleitungen **6** bzw. **7** verbunden. Die Schichten **2** und **3** sollen dabei eine oder mehrere gegebenenfalls notwendige Zwischenschichten (Barrierematerial, Lot, Haftvermittler o.ä.) zwischen dem Material **1** und den Kontakten **4** und **5** symbolisieren. Die jeweils paarweise zueinander gehörenden Segmente **2**/**3**, **4**/**5**, **6**/**7** können, müssen aber nicht identisch sein. Dies hängt letztlich ebenfalls vom spezifischen Aufbau und der Anwendung ab, ebenso wie auch die Flussrichtung von elektrischem Strom bzw. Wärmestrom durch den Aufbau.

Um dem ganzen Gefüge Stabilität zu verleihen und die notwendige, möglichst homogene Wärmeankoppelung über die Gesamtzahl der Schenkel zu gewährleisten, sind Trägerplatten notwendig. Hierzu wird üblicherweise eine Keramik genutzt, beispielsweise aus Oxiden oder Nitriden wie Al₂O₃, SiO₂ oder AIN.

Dieser typische Aufbau bringt eine Reihe von Nachteilen mit sich. Die Keramik sowie die Kontakte sind nur begrenzt mechanisch belastbar. Mechanische und/oder thermische Spannungen können leicht zu Rissen oder einem Abriss der Kontaktierung führen, die das gesamte Modul unbrauchbar machen.

Weiterhin sind dem klassischen Aufbau auch im Hinblick auf eine Anwendung Grenzen gesetzt, da stets nur planare Flächen mit dem thermoelektrischen Modul in Verbindung gebracht werden können. Eine enge Verbindung zwischen der Moduloberfläche und der Wärmequelle/Wärmesenke ist unerlässlich, um für einen ausreichenden Wärmefluss zu sorgen.

Nicht planare Oberflächen, wie beispielsweise ein rundes Abwärmerohr, sind einem direkten Kontakt mit dem klassischen Modul nicht zugänglich oder erfordern einen entsprechenden begradigten Wärmetauscheraufbau, um einen Übergang von der nichtplanaren Oberfläche zum planaren Modul zu schaffen.

Geeignete Halbleitermaterialien sind beispielsweise beschrieben in S. Nolan et al., Recent Developments in Bulk Thermoelectric Materials, MRS Bulletin, Vol. 31, 2006, 199 - 206. Bevorzugte Materialien basieren z. B. auf PbTe.

Die Herstellung der thermoelektrischen Halbleitermaterialien erfolgt nach dem Stand der Technik beispielsweise durch Zusammenschmelzen von Mischungen der jeweiligen Elementbestandteile oder deren Legierungen in einem heizbaren Quarzrohr unter Verwendung eines dreh- und/oder kippbaren Ofens. Das so erhaltene Material wird zu Formkörpern verarbeitet, z. B. durch Mahlen, Pressen und/oder Sintern. Ein entsprechendes Verfahren ist in WO 2007/104601 beschrieben.

Die Verarbeitung von thermoelektrischen Halbleitermaterialien durch Heißisostatisches Pressen ist beispielsweise in DE-A-3704372 beschrieben. Es ist angegeben, dass ein besonders homogenes Material praktisch ohne Korngrenzenabscheidungen bei völliger Porenfreiheit erhalten werden kann.

US 2004/0187905 beschreibt die Herstellung eines Bulkmaterials des thermoelektrischen Halbleitermaterials, das sodann in ein Pulver zermahlen wird. Nach einem Klassieren des Pulvers wird eine ausgewählte Pulverfraktion bei Raumtemperatur verpresst und nachfolgend in einem Ofen gesintert.

Die Verfahren sind teilweise aufwendig und erlauben häufig nur die Ausbildung einfacher Geometrien.

EP-A-1 083 610 betrifft ein thermoelektrisches Material und ein Verfahren zu seiner Herstellung. Es ist beschrieben, dass Silizium und Zusatzelemente in eine Graphitform gegeben und in einem Hochfrequenz-Schmelzofen geschmolzen werden.

US 3,867,496 betrifft ein Verfahren oder eine Vorrichtung zur Herstellung von feinkörnigen polykristallinen, thermoelektrischen Materialien. Die Inhaltsstoffe des gewünschten Materials werden in einem Behältnis vorgelegt und durch Induktionsschmelzen aufgeschmolzen. Dazu werden zwei Induktionsheizelemente am Behältnis vorgesehen.

US 3,527,622 betrifft eine thermoelektrische Zusammensetzung und einen daraus hergestellten Schenkel. Die zur Herstellung des Materials eingesetzten Elemente werden in einem Reagenzglas eingeschmolzen und mithilfe einer Induktionsheizung aufgeschmolzen.

DE-A-10 2007 014 499 betrifft mit Zinn-Antimon-Telluriden dotierte Pb-Te-Verbindungen für thermoelelctrische Generatoren und Peltier-Anordnungen. Es ist beschrieben, dass die Herstellung der Halbleitermaterialien durch Zusammenschmelzen von Mischungen der Elementpulver der Bestandteile oder deren Legierungen erfolgen kann. Ein Induktionsschmelzen ist nicht beschrieben.

Der Abschnitt 9 "Preparation of Thermoelectric Materials from Melts" des CRC-Handbooks 1995 beschreibt die Herstellung thermoelektrischer Materialien. Dazu werden die Ausgangsmaterialien gemeinsam in Quarz-Ampullen eingeschmolzen. Es ist beschrieben, dass die Herstellung von Si₈₀Ge₂₀-Legierungen in einem Radiofrequenz-Ofen erfolgt.

Aufgabe der vorliegenden Erfindung ist die Bereitstellung eines Verfahrens zur Herstellung thermoelektrischer Halbleitermaterialien durch Zusammenschmelzen von Mi schungen der jeweiligen Elementbestandteile der thermoelektrischen Halbleitermaterialien oder deren Legierungen, das eine besonders homogene Verteilung von Dopanden im thermoelektrischen Halbleitermaterial erlaubt und in unaufwendiger Weise die direkte Herstellung thermoelektrischer Schenkel ermöglicht.

Die Aufgabe wird erfindungsgemäß gelöst durch ein Verfahren zur Herstellung thermoelektrischer Schenkel und Baueinheiten für thermoelektrische Module durch Zusammenschmelzen von Mischungen der jeweiligen Elementbestandteile der thermoelektrischen Halbleitermaterialien oder deren Legierungen in einem Induktionsofen und Gießen der so erhaltenen Schmelze in die Form eines thermoelektrischen Schenkels oder Versprühen der so erhaltenen Schmelze zur Herstellung eines pulverförmigen thermoelektrischen Halbleitermaterials, wobei zunächst Elementbestandteile der thermoelektrischen Halbleitermaterialien oder ihre Legierungen mit geringer Reaktivität zusammengeschmolzen werden und nachfolgend Elementbestandteile der thermoelektrischen Materialien oder ihre Legierungen mit höherer Reaktivität zu dieser Schmelze zugesetzt werden. Die versprühte Schmelze führt zu einer mittleren Teilchengröße von vorzugsweise 1 µm bis 5 mm, besonders bevorzugt 1 µm bis 1 mm, insbesondere 1 bis 500 µm. Die versprühte Schmelze kann auf einer gekühlten festen Oberfläche, in einem Flüssigmedium oder durch Gas-Gegenstrom abgekühlt werden.

Es wurde erfindungsgemäß gefunden, dass Induktionsöfen in vorteilhafter Weise ein Zusammenschmelzen thermoelektrischer Halbleitermaterialien ermöglichen, wobei unmittelbar anschließend eine Formgebung durchgeführt werden kann.

Durch die vorliegende Erfindung von Material- bis Modulherstellung können Teile der Arbeitsschritte eingespart oder vereinfacht werden.

Es wurde erfindungsgemäß gefunden, dass besonders vorteilhafte homogen gemischte thermoelektrische Halbleitermaterialien zugänglich sind, wenn zunächst Elementbestandteile der thermoelektrischen Halbleitermaterialien oder ihre Legierungen mit geringer Reaktivität zusammengeschmolzen werden und nachfolgend Elementbestandteile der thermoelektrischen Materialien oder ihre Legierungen mit höherer Reaktivität zu dieser Schmelze zugesetzt werden. Im Grundsatz werden dabei die Komponenten entsprechend ihrer Reaktionsgeschwindigkeit umgesetzt, wobei mit Komponenten mit niedriger Umsetzungsgeschwindigkeit begonnen wird, die zunächst mit den Hauptbestandteilen des thermoelektrischen Halbleitermaterials umgesetzt werden. Nachfolgend werden Komponenten mit kürzerer Reaktionszeit zugesetzt.

Beispielsweise kann das thermoelektrische Halbleitermaterial ein dotiertes Bleitellurid sein, wobei zunächst Bleitellurid oder Blei und Tellur mit Dopanden niedriger Reaktivität zusammengeschmolzen wird/werden und nachfolgend Dopanden höherer Reaktivität zu dieser Schmelze zugesetzt werden.

Dieses mehrstufige Batch-Verfahren erlaubt die Herstellung von Materialien mit verbesserten thermoelektrischen Eigenschaften und exzellenter Homogenität. Auf eine zusätzliche Materialhomogenisierung z. B. durch nachträgliche Temperung und/oder mechanische Vermischung kann damit in der Regel verzichtet werden.

Elementbestandteile oder Legierungen mit geringer Reaktivität sind beispielsweise Al, Si, B, Ti, Zr, Hf, Nb, Ta, Cr, Mo, W, Cu, Co, Ni und/oder Edelmetalle.

Elementbestandteile mit höherer Reaktivität sind beispielsweise Alkalimetalle, Erdalkalimetalle, Sn, Ga, In, TI, As, P, Sb, Bi, S, Se, Te, Halogenide, Chalkogenide, V, Mn, Fe, Zn, Cd.

Der Aufbau der im erfindungsgemäßen Verfahren eingesetzten Induktionsöfen unterliegt keinen besonderen Beschränkungen. Ein Induktionsofen überträgt die Energie mittels eines Schwingkreises oder einer Spule. Das Erwärmen wird durch Induktion eines Wirbelstroms in dem thermoelektrischen Halbleitermaterial erreicht. Kernstück des Induktionsofens ist die Induktionsspule, in der sich ein magnetisches Wechselfeld aufbaut, wenn sie von einem Wechselstrom durchflossen wird.

Im erfindungsgemäßen Verfahren werden die geschmolzenen thermoelektrischen Halbleitermaterialien direkt aus der Schmelze in die Form eines thermoelektrischen Schenkels gebracht, z. B. durch Gießen, Stranggießen oder Erstarren. Dabei können beliebige geeignete Formen für den thermoelektrischen Schenkel ausgewählt werden. Die thermoelektrischen Schenkel können sodann aus der Form entnommen werden.

Besonders vorteilhaft ist es, wenn das Gießen der Schmelze des thermoelektrischen Halbleitermaterials in eine Matrixform aus einem Matrixmaterial mit geringer thermischer Leitfähigkeit und vernachlässigbarer elektrischer Leitfähigkeit drucklos, unter Vakuum oder unter Druck erfolgt, die mehrere Aussparungen zur Aufnahme des thermoelektrischen Halbleitermaterials aufweist, wobei die Matrix mit dem darin eingeschlossenen thermoelektrischen Halbleitermaterial Teil eines späteren thermoelektrischen Moduls wird.

Das Matrixmaterial kann dabei aus beliebigen geeigneten Materialien aufgebaut sein, sofern sie eine geringe thermische Leitfähigkeit mit elektrischen Isolationseigenschaften kombinieren und bei der Temperatur des geschmolzenen thermoelektrischen Halbleitermaterials formbeständig sind. Bevorzugt enthält das Matrixmaterial ein keramisches Material oder ein Gemisch aus keramischem Material und Glas, Glimmer, Aerogel oder eine Kombination dieser Materialien. Auch organische Polymermaterialien können eingesetzt werden, sofern die Schmelztemperatur höher als die Anwendungstemperatur ist. Die Matrix verleiht einem späteren thermoelektrischen Modul Stabilität, erlaubt eine einfache Modulherstellung und schützt das thermoelektrische System aus Materialien und Kontakten vor Abbau und Kontaminierung aufgrund äußerer Einflüsse wie Feuchtigkeit, Sauerstoff und Chemikalien sowie eine gegenseitige Kontamination der n- und p-Schenkel durch Sublimation des thermoelektrischen Materials. Die Matrix enthält die vorstehenden Materialien oder besteht aus ihr. Es handelt sich um Materialien oder Materialgemische mit niedriger thermischer Leitfähigkeit, so dass bei der späteren Anwendung die Wärme durch das thermoelektrische Material und nicht durch die Matrix fließt.

Das Matrixmaterial kann durch beliebige Prozesse in eine geeignete Form gebracht werden. Die Matrix kann beispielsweise durch Spritzgießen oder Extrusion in die geeignete Form gebracht werden. Diese Form weist Aussparungen zur Aufnahme des thermoelektrischen Halbleitermaterials auf, so dass es die Ausbildung thermoelektrischer Module erlaubt. Vorzugsweise liegen zahlreiche Aussparungen im Matrixmaterial vor. Die Matrix kann dabei jede beliebige geeignete dreidimensionale Form aufweisen. Sie kann beispielsweise flächig oder gekrümmt ausgebildet sein. Bei einer flächigen Ausbildung sind die Aussparungen zur Aufnahme des thermoelektrischen Halbleitermaterials vorzugsweise senkrecht zur Fläche ausgebildet.

Dabei nehmen die Aussparungen vorzugsweise den größeren Teil der räumlichen Ausdehnung des Matrixmaterials ein, damit im späteren thermoelektrischen Modul eine hoher Füllgrad des thermoelektrischen Halbleitermaterials vorliegt. Beispielsweise können die Aussparungen in Form einer Wabenstruktur vorliegen, wie sie von Autoabgaskatalysatoren bekannt sind. Im Matrixmaterial können auch Reihen von Aussparungen vorliegen, wobei die angrenzenden Reihen seitlich gegeneinander verschoben sein können.

Das Matrixmaterial ist dabei typischerweise so ausgebildet, dass die verbleibenden Aussparungen für die thermoelektrischen Schenkel dem Aufbau eines typischen thermoelektrischen Moduls entsprechen.

Ein niedrigerer Füllgrad kann bei großen Flächen oder wenn der Wärmefluss pro Fläche nicht ausreichend ist, sinnvoll sein.

Da zur Ausbildung eines thermoelektrischen Moduls p- und n-leitende thermoelektrische Halbleitermaterialien abwechselnd miteinander verbunden sein müssen, werden bevorzugt alternierend p- und n-leitende thermoelektrische Halbleitermaterialien in die Aussparungen gegossen. Alternativ ist es möglich, jede Aussparung hälftig mit p- und n-leitenden thermoelektrischen Halbleitermaterialien zur direkten Ausbildung von thermoelektrischen Schenkelpaaren zu füllen, wobei die Schenkel elektrisch voneinander isoliert sind.

Im erfindungsgemäßen Verfahren werden die Ausgangsmaterialien in der gewünschten Stöchiometrie in ein Gefäß, vorzugsweise aus Keramik, Quarz oder Graphit, gegeben, und in einem Induktionsofen umgesetzt.

Zur Verbesserung der Homogenität und der thermoelektrischen Eigenschaften erfolgt ein wie vorstehend beschriebenes zweistufiges oder mehrstufiges Induktionsschmelzen, wobei zunächst mit Ausgangsmaterialien oder Dopanden mit niedriger Reaktionsgeschwindigkeit gestartet wird, und später Ausgangsmaterialien oder Dopanden höherer Reaktivität zugesetzt werden. Zum Befüllen der Aussparungen wird die Matrix vorzugsweise an der Austrittsöffnung des Induktionsofens vorbeigeführt. Beispielsweise kann ein Matrixstrang über ein Laufband an der Austrittsöffnung des Induktionsofens vorbeigeführt werden, wobei die Fortbewegung so stufenweise geregelt ist, dass jeweils die Aussparungen mit thermoelektrischem Halbleitermaterial ausgefüllt werden können.

Die Form der Matrix kann beliebig gewählt werden, nur muss die Matrix entsprechend so an der Austrittsöffnung des Induktionsofens vorbei bewegt werden, dass alle Aussparungen nacheinander befüllt werden können. Das Abfüllen sollte bevorzugt unter Inertgasatmosphäre erfolgen, um eine Oxidation der thermoelektrischen Halbleitermaterialien zu vermeiden. Die Matrixform kann beispielsweise eine Platte oder ein Zylinder oder eine andere geometrische Form sein. Auch die Aussparungen können eine beliebige geometrische Form aufweisen. Vorzugsweise weisen die Aussparungen Zylinder- oder Kubusform auf. Eine besonders geeignete Form ist die Wabenform der Matrix aufgrund der hohen Hohlraumdichte, die mit thermoelektrischem Halbleitermaterial befüllt werden kann und der dünnen elektrisch isolierenden Wände.

Das erfindungsgemäße Verfahren hat den Vorteil, dass vorzugsweise nur das thermoelektrische Halbleitermaterial im Induktionsofen erwärmt wird. Das Matrixmaterial wird nicht oder nur untergeordnet durch Induktion aufgeheizt, sodass eine chemische Kontamination des thermoelektrischen Halbleitermaterials verhindert werden kann.

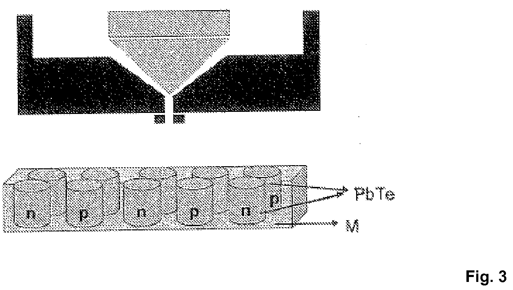

Figur 3 zeigt den prinzipiellen Aufbau des erfindungsgemäßen Verfahrens. Im oberen Teil ist der Induktionsofen mit dem darin enthaltenen thermoelektrischen Halbleitermaterial gezeigt. Das Material wird durch einen Auslass, beispielsweise in Schlitzdüsenform, in eine Matrix M gegossen. Als Beispiel ist ein PbTe-thermoelektrisches Material angegeben.

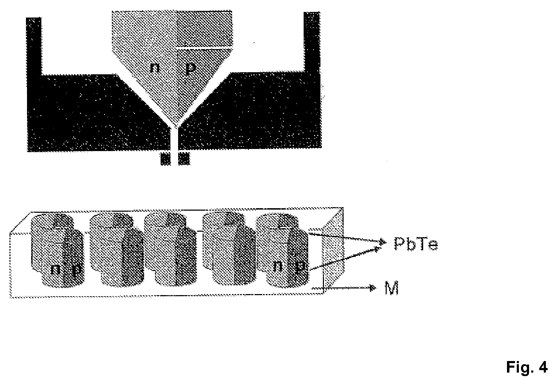

Die in-situ-Schenkelpaar-Herstellung in einer Matrix ist in Figur 4 gezeigt. Dort werden die Aussparungen der Matrix M jeweils hälftig mit p- und n-leitenden thermoelektrischen Materialien (im Beispiel PbTe) gefüllt.
In den Figuren 3 und 4 ist die Matrix flächig dargestellt. Ein entsprechendes Matrixband kann jedoch auch zu einem Ring oder Zylinder zusammengerollt oder verformt werden, wobei ein entsprechender Ring dann unter Drehung an der Austrittsöffnung des Induktionsofens vorbeigeführt wird.

Die Matrix sorgt nicht nur für eine gute mechanische Stabilität des Moduls, sondern ermöglicht auch einen Schutz gegen eine Oxidation, Sublimation oder Kreuz-Kontaminierung der thermoelektrischen Halbleitermaterialien. Durch entsprechende Ausformung des Matrixmaterials sind dreidimensionale Strukturen der späteren thermoelektrischen Module zugänglich, die an die jeweilige Anwendung angepasst werden können. Nach dem Einbringen der thermoelektrischen Halbleitermaterialien muss eine Kontaktierung, wie sie eingangs beschrieben ist, durchgeführt werden. Dabei können elektrische Kontakte vorzugsweise auf die thermoelektrischen Schenkel durch Induktionslöten oder Induktionsschweißen aufgebracht werden. Die Kontakte können Flexibilitätsstellen aufweisen, um eine Widerstandsfähigkeit gegen thermische Belastungen zu zeigen. Federnde Verbindungen oder Verbindungen mit Ausgleichselementen für thermische Ausdehnung erlauben die Implementierung oder Integration in Kühl- oder Heizsysteme. Das thermoelektrische Modul kann beispielsweise in Rohre oder Abgassysteme integriert werden, sofern die Rohre elektrisch isoliert werden. Die Kontaktierung kann auch wie in Mat. Res. Soc. Symp. Proc. Vol. 234, 1991, Seiten 167 bis 177 beschrieben erfolgen. Vorteilhaft beim Induktionslöten oder Induktionsschweißen ist das sehr schnelle Aufheizen und Abkühlen der thermoelektrischen Schenkel und der Verbindungsstellen. Insbesondere ist das Verschweißen für die Hochtemperaturseiten der thermoelektrischen Schenkel empfehlenswert, während auf der kalten Seite auch ein übliches Verlöten durchgeführt werden kann. Aufgrund der Matrixstruktur ist die gleichzeitige Verbindung zahlreicher thermoelektrischer Schenkel in einem Schritt möglich.

Vor dem Induktionsschweißen können, sofern notwendig, eine oder mehrere gegebenenfalls notwendige Zwischenschichten wie Barrierematerial oder Haftvermittler aufgebracht werden. Zuvor kann, falls erforderlich, poliert, geläppt oder planparallel ausgerichtet werden.

Erfindungsgemäß ist es bevorzugt, die durch Induktionsschmelzen erhaltene Schmelze direkt in die Form eines thermoelektrischen Schenkels zu gießen. Sofern in Ausnahmefällen nach der Synthese die Homogenität des Materials nicht zufrieden stellend ist, kann nach dem Erstarren der Schmelze das Material vermahlen werden, wonach das erhaltene Pulver wiederum in den Induktionsofen gefüllt wird, erneut (schnell) zum Schmelzen gebracht wird und dann in die Schenkelform gegossen wird.

Statt Homogenisierung und Zerkleinerung des thermoelektrischen Materials durch Mahlen des Grünkörpers nach der Synthese hat sich die Herstellung eines Pulvers des thermoelektrischen Materials direkt aus der Schmelze als vorteilhaft erwiesen. Dabei wird die Schmelze durch eine Öffnung in dem Tiegelboden versprüht. Besonders vorteilhaft hat sich die Versprühung in ein Inert-Gas Gegenstrom erwiesen. Dabei wird die Schmelze mit Druck über eine Öffnung in dem Reaktionstiegel in einen Turm versprüht. In diesen Turm wird ein Gegenstrom von Inertgas oder Inertgas/H₂ eingeleitet. Die Öffnung des Reaktionstiegels sollte noch beheizt werden, um eine Verstopfung des Tiegels zu vermeiden. Dabei wird das thermoelektrische Material in einer Pulvergröße zwischen 100 nm und 5 mm hergestellt. Das erfindungsgemäße Verfahren hat den Vorteil, dass eine breitere Korngrößenverteilung des thermoelektrischen Pulvers herstellbar ist, was sich für eine gute Induktionssinterung als besonders vorteilhaft erwiesen hat. Weiterhin kann als Abkühlmedium auch ein Flüssigmedium (Öle, Silikonöl, organische Lösungsmittel und Wasser) oder eine Festmedium (Metal-, Glas-, Keramikband oder Boden) verwendet werden.

Es ist dabei auch möglich, das pulverförmige thermoelektrische Halbleitermaterial direkt in die Aussparungen der Matrixform einzubringen und unter Verpressen in einem Induktionsofen zu sintern. Auch so ist erfindungsgemäß die Herstellung thermoelektrischer Schenkel in einer Matrixform aus einem Matrixmaterial mit geringer thermischer Leitfähigkeit und ohne elektrische Leitfähigkeit möglich. Das mittels Induktion hergestellte Pulver des thermoelektrischen Materials kann nach bekannten Verfahren zu Schenkeln verarbeitet werden, siehe z. B. WO 2007/104601, und elektrisch kontaktiert werden, siehe oben.

Zur Herstellung sehr dichter Materialien kann das Sintern mit einem Verpressen kombiniert werden. Die Sintertemperatur kann dabei frei gewählt werden. Für PbTe-Materialien beträgt die Sintertemperatur vorzugsweise 300 bis 800 °C, besonders bevorzugt 500 bis 800 °C. Die Sinterzeit kann durch Induktionsheizen dabei von wenigen Sekunden bis zu Stunden betragen. Bevorzugt sind Sinterzeiten im Sekunden - oder Minutenbereich. Beim Sintern sollte auf eine Inertgasatmosphäre geachtet werden.

Die Erfindung wird durch die nachstehenden Beispiele näher erläutert.

### Referenz-Beispiele

### 1) Herstellung thermoelektrische Materialien und Schenkel durch Induktionsheizen

Für die Versuche wurden kommerziel erhältliche Edukte verwendet.
Pb: Barren à 5 kg, Reinheit > 99.99 %. Die Pb-Barren wurden von der oberflächlich anhaftenden Oxidschicht gereinigt und zerspant. Die Späne wurden direkt für die Synthesen eingesetzt.
Te: Barren à 5 kg, Reinheit > 99.999 %. Die Te-Barren wurden grob vorzerkleinert und die Stücke direkt für die Synthesen eingesetzt.

Dopanden (Sn, Ge): Reinheit > 99.9 %, Die Metall-Barren wurden manuell zerkleinert und die Bruchstücke als Dotierung entweder direkt für die Synthesen oder als Vorlegierung eingesetzt.

Für die Materialherstellung wurde ein Induktionsofen mit eine Innenraumvolumen von 1500 cm³, maximale Leistung von 25 kW, max Temperatur von 1500 °C, Frequenzbereich 4 -5.5 kHz verwendet.

Die Regeltemperatur wurde an der Tiegelwandung mit einem Ni/CrNi-Thermoelement (gesichert in einem Keramikschutzrohr) erfaßt. Eine Vergleichsmessung erfolgte stichprobenartig auch direkt in der Schmelze durch ein absenkbares, keramikumhülltes Thermoelement. Zu diesem Zweck war im Tiegeldeckel eine kleine Bohrung angebracht, die (sofern das Thermoelement nicht eingesteckt war) mit einem Keramikpapier bedeckt wurde.

Die Edukte wurden in entsprechenden Stoffmengenverhältnis in den Sigradurtiegel gefüllt.

Vor Versuchsbeginn wurde der Ofen mehrmals evakuiert und wieder mit Argon geflutet.

Folgende Fahrweise wurde durchgeführt: Aufheizen auf 1050 °C, ca. 100 K min⁻¹, Halten bei 1050 °C, für 160 min. Die Schmelze wurde anschließend in eine Keramikform, auf 800 °C vorgeheizt, unter leichtem Ar/H₂-Druck (0,2 bar) gegossen.

### 2) Herstellung thermoelektrischer Schenkel durch Induktionssintern

2,3 g Pulver (Korngröße 1µm - 1 mm) des thermoelektrischen Materials wurden in einen Grafittiegel mit Grafitstempel eingefüllt. Den Tiegel wurde in einen Induktionsofen VC500 (Hersteller Firma Indutherm GmbH) eingeführt. Den Ofenraum wurde mit Ar/H₂-Gas auf 0,2 mbar befüllt. Eine Temperatur von 700 °C wurde eingestellt (Leistung 1,2-14,5 kW) und über zwei Thermoelementen in der Tiegelwand und in der Stempelwand kontrolliert. Nach Erreichen der Temperatur wurden ein Druck von 3 bar auf die Probe angelegt und für 5 min gehalten. Anschließend wurden der Druck entspannt und die Induktionsheizung ausgeschaltet. Die Probe hatte eine Dichte von 95 % des theoretischen Wertes.

### 3) Herstellung der elektrischen Kontaktierung durch Induktionsintern/Pressen

Analog Versuch 2) wurden auf den Boden des Tiegels zuerst die Elektrode gelegt und anschließend das Pulver. Für die Kontaktierung eines Schenkelspaars von n- und p-Material wurde der Tiegel durch eine Grafitwand (entfernbar nach der Sinterung) oder Glimmerwand (keine Entfernung notwendig nach der Sinterung) geteilt. Anschließend wurde die Sinterung und Kontaktierung in eine Schritt wie in Versuch 2 beschrieben durchgeführt.

## Patentansprüche

1. Verfahren zur Herstellung thermoelektrischer Halbleitermaterialien durch Zusammenschmelzen von Mischungen der jeweiligen Elementbestandteile der thermoelektrischen Halbleitermaterialien oder deren Legierungen in einem Induktionsofen und Gießen der so erhaltenen Schmelze in die Form eines thermoelektrischen Schenkels oder Versprühen der so erhaltenen Schmelze zur Herstellung eines pulverförmigen thermoelektrischen Halbleitermaterials, wobei zunächst Elementbestandteile der thermoelektrischen Halbleitermaterialien oder ihre Legierungen mit geringer Reaktivität zusammengeschmolzen werden und nachfolgend Elementbestandteile der thermoelektrischen Materialien oder ihre Legierungen mit höherer Reaktivität zu dieser Schmelze zugesetzt werden.

2. Verfahren nach Anspruch 1, **dadurch gekennzeichnet, dass** das thermoelektrische Halbleitermaterial ein dotiertes Bleitellurid ist und zunächst Bleitellurid oder Blei und Tellur mit Dopanden niedriger Reaktivität zusammengeschmolzen wird und nachfolgend Dopanden höherer Reaktivität zu dieser Schmelze zugesetzt werden.

3. Verfahren nach einem der Ansprüche 1 oder 2, **dadurch gekennzeichnet, dass** das Gießen der Schmelze des thermoelektrischen Halbleitermaterials in eine Matrixform aus einem Matrixmaterial mit geringer thermischer Leitfähigkeit und vernachlässigbarer elektrischer Leitfähigkeit drucklos, unter Vakuum oder unter Druck erfolgt, die mehrere Aussparungen zur Aufnahme des thermoelektrischen Halbleitermaterials aufweist, wobei die Matrix mit dem darin eingeschlossenen thermoelektrischen Halbleitermaterial Teil eines späteren thermoelektrischen Moduls wird.

4. Verfahren nach Anspruch 3, **dadurch gekennzeichnet, dass** die Matrix flächig ausgebildet ist und die Aussparungen zur Aufnahme des thermoelektrischen Halbleitermaterials senkrecht zur Fläche ausgebildet sind.

5. Verfahren nach Anspruch 4, **dadurch gekennzeichnet, dass** die Aussparungen in Form einer Wabenstruktur vorliegen.

6. Verfahren nach einem der Ansprüche 3 bis 5, **dadurch gekennzeichnet, dass** in die Aussparungen alternierend p- und n-feitende thermoelektrische Halbleitermaterialien gegossen werden, oder jede Aussparung hälftig mit p- und n-leitenden thermoelektrischen Halbleitermaterialien zur direkten Ausbildung von thermoelektrischen Schenkelpaaren ausgegossen wird.

7. Verfahren nach einem der Ansprüche 3 bis 6, **dadurch gekennzeichnet, dass** nachfolgend elektrische Kontakte auf die thermoelektrischen Schenkel durch Induktionslöten oder In duktionsschweißen aufgebracht werden.

## Claims

1. A process for producing thermoelectric semiconductor materials by co-melting mixtures of the particular element constituents of the thermoelectric semiconductor materials or alloys thereof in an induction furnace and pouring the melt thus obtained into the mold of a thermoelectric leg, or spraying the melt thus obtained to produce a pulverulent thermoelectric semiconductor material, wherein element constituents of the thermoelectric semiconductor materials or low-reactivity alloys thereof are first co-melted, and then element constituents of the thermoelectric materials or higher-reactivity alloys thereof are added to this melt.

2. The process according to claim 1, wherein the thermoelectric semiconductor material is a doped lead telluride, and lead telluride is, or lead and tellurium are, first co-melted with low-reactivity dopants, and then higher-reactivity dopants are added to this melt.

3. The process according to either of claims 1 and 2, wherein the melt of the thermoelectric semiconductor material is poured under ambient pressure, under reduced pressure or under pressure into a matrix mold which is composed of a matrix material with low thermal conductivity and negligible electrical conductivity and has a plurality of recesses for accommodating the thermoelectric semiconductor material, the matrix with the thermoelectric semiconductor material enclosed therein becoming part of a later thermoelectric module.

4. The process according to claim 3, wherein the matrix has a flat configuration and the recesses for accommodating the thermoelectric semiconductor material are configured at right angles to the surface.

5. The process according to claim 4, wherein the recesses are present in the form of a honeycomb structure.

6. The process according to any of claims 3 to 5, wherein p- and n-conductive thermoelectric semiconductor materials are poured into alternating recesses, or each recess is filled half with p-conductive and half with n-conductive thermoelectric semiconductor materials to directly form thermoelectric leg pairs.

7. The process according to any of claims 3 to 6, wherein electrical contacts are subsequently applied to the thermoelectric legs by induction soldering or induction welding.

## Revendications

1. Procédé pour la fabrication de matériaux semi-conducteurs thermoélectriques par fusion de mélanges des différents constituants élémentaires des matériaux semi-conducteurs thermoélectriques ou de leurs alliages dans un four à induction et moulage de la masse fondue ainsi obtenue sous forme d'une branche thermoélectrique ou pulvérisation de la masse fondue ainsi obtenue pour fabriquer un matériau semi-conducteur thermoélectrique sous forme de poudre, les constituants élémentaires des matériaux semi-conducteurs thermoélectriques ou leurs alliages présentant une faible réactivité étant d'abord fondus et les constituants élémentaires des matériaux thermoélectriques ou leurs alliages présentant une réactivité supérieure étant ensuite ajoutés à cette masse fondue.

2. Procédé selon la revendication 1, **caractérisé en ce que** le matériau semi-conducteur thermoélectrique est un tellurure de plomb dopé et le tellurure de plomb ou le plomb et le tellure sont d'abord fondus avec des dopants de faible réactivité et les dopants de réactivité supérieure sont ensuite ajoutés à cette masse fondue.

3. Procédé selon l'une quelconque des revendications 1 ou 2, **caractérisé en ce que** le moulage de la masse fondue du matériau semi-conducteur thermoélectrique a lieu dans un moule de matrice en un matériau de matrice présentant une faible conductibilité thermique et une conductibilité électrique négligeable, sans pression, sous vide ou sous une pression, qui présente plusieurs évidements pour recevoir le matériau semi-conducteur thermoélectrique, la matrice présentant le matériau semi-conducteur thermoélectrique enfermé en son sein devenant une partie d'un module thermoélectrique ultérieur.

4. Procédé selon la revendication 3, **caractérisé en ce que** la matrice est conçue sous forme plate et les évidements pour recevoir le matériau semi-conducteur thermoélectrique sont réalisés perpendiculairement par rapport à la surface.

5. Procédé selon la revendication 4, **caractérisé en ce que** les évidements se trouvent sous forme d'une structure en nid d'abeille.

6. Procédé selon l'une quelconque des revendications 3 à 5, **caractérisé en ce qu'**on moule dans les évidements, alternativement, des matériaux semi-conducteurs thermoélectriques de type p et de type n ou on remplit chaque évidement à moitié par des matériaux semi-conducteurs thermoélectriques de type p et de type n pour la formation directe de paires de branches thermoélectriques.

7. Procédé selon l'une quelconque des revendications 3 à 6, **caractérisé en ce que** des contacts électriques sont ensuite appliqués sur les branches thermoélectriques par brasage par induction ou par soudage par induction.
